# EUROPEAN PATENT SPECIFICATION

(11) **EP 3 438 855 B1**
(45) Date of publication and mention of the grant of the patent: **03.05.2023**
(21) Application number: 16896190.2
(22) Date of filing: 31.05.2016
(51) Int. Cl.: B03C 3/36, B03C 3/38, H01T 23/00

(54) **ION AIR SUPPLY MODULE NEEDLE NET LAYOUT METHOD AND ION AIR SUPPLY MODULE**
VERFAHREN ZUM NADEL/NETZ-LAYOUT FÜR IONEN-LUFT-VERSORGUNGSMODUL UND EIN IONEN-LUFT-VERSORGUNGSMODUL
PROCÉDÉ DE DISPOSITION AIGUILLE/FILET DE MODULE D'ALIMENTATION EN AIR IONISÉ ET MODULE D'ALIMENTATION EN AIR IONISÉ

(30) Priority: 28.03.2016 CN 201610180852
(43) Date of publication of application: 06.02.2019
(73) Proprietor: Qingdao Haier Smart Technology R&D Co., Ltd., Shandong 266101 (CN); Harbin Institute Of Technology, Harbin, Heilongjiang 150001 (CN)
(72) Inventor: TANG, Jingfeng, Qingdao Shandong 266101 (CN); WEI, Liqiu, Qingdao Shandong 266101 (CN); YU, Daren, Qingdao Shandong 266101 (CN); WANG, Yongtao, Qingdao Shandong 266101 (CN); ZHANG, Lichen, Qingdao Shandong 266101 (CN); LI, Jian, Qingdao Shandong 266101 (CN); WANG, Jingjing, Qingdao Shandong 266101 (CN); MA, Zhuang, Qingdao Shandong 266101 (CN); TANG, Linqiang, Qingdao Shandong 266101 (CN)
(74) Representative: Byrne, Declan
(86) International application number: PCT/CN2016/083993
(87) International publication number: WO 2017/166416

(56) References cited:
- CN-A- 103 368 077
- CN-U- 204 005 880
- JP-A- S59 193 158
- US-A- 3 751 715
- US-A- 4 689 056
- US-B1- 6 228 149
- WEI, JIE: "Study on Funnel Cooling Device Based on Electrohydrodynamics", ELECTRONIC TECHNOLOGY & INFORMATION SCIENCE , CHINA MASTER'S THESES FULL-TEXT DATABASE, 15 August 2015 (2015-08-15), pages 1-93, XP009510292, ISSN: 1674-0246

## Description

### Technical Field

The invention relates to the technical field of ionic wind, and in particular to a needle-to-mesh electrode configuration method of an ionic wind generating module.

### Background

Relying on the advantages of being simple in structure, noise-free and capable of being used in air purifier, the ionic wind created by corona discharge becomes an attractive study area all across the world with great market potential and prospects. The ionic wind is the creation of movement of air by means of a corona discharge: high voltage is applied on emitter needle electrode to create an electric field in the vicinity of the tip of the emitter needle which is strong enough to ionize gas molecules in the dielectric surrounding while out of the area the electric field is comparatively weak where ionization barely occurs. Charged particles are induced to move by the strong electric field, and in the process, they will undergo collisions with neutral particles and give them momentum to enable them to flow together, and thereby generating the ionic wind. Practically in the prior art, as the detailed number of needle electrons and the position of a metallic mesh are being determined, the applied voltage is raised to produce higher ionic wind velocity. However, if the applied voltage is raised too much, the discharge will change into a spark and further cause a voltage drop between the emitter electrode and the collector electrode, which results in extremely weak ionic wind or no ionic wind.

Accordingly, the ionic wind velocity and intensity produced by the traditional ionic wind generator with a needle-to-mesh configuration, and its efficiency are far from satisfactory.

Provided by the present invention are a needle-to-mesh electrode configuration method of ionic wind generating module according to claim 1 in order to improve the air velocity, intensity and efficiency of the traditional ionic wind generating US4689056 discloses an air cleaner using an ionic wind having discharge electrodes, a counter electrode arranged downstream of the discharge electrodes, and first and second parallel plate electrodes arranged alternately downstream of the counter electrode. The second parallel plate electrodes are connected to a potential pick-up electrode arranged in the vicinity of the discharge electrodes. The first and second parallel plate electrodes which are arranged alternately serve as dust collecting electrodes module.

### Technical solution

A needle-to-mesh electrode configuration method of ionic wind generating module, wherein the ionic wind generating module comprising a metallic mesh and a plurality of emitter needles in an array disposed at one side of the metallic mesh, comprises:

Step 1: ionic wind velocity test, which comprising: adjusting the distance between a single emitter needle and the metallic mesh to enable the ionic wind velocity at a corresponding air velocity central point on the metallic mesh to reach the maximum value under the premise that the voltage between the emitter needle and the metallic mesh is unchanged; measuring the adjusted distance ***L*** between the one emitter needle and the metallic mesh as the ionic wind velocity at the corresponding air velocity central point maintaining at its maximum value ***Vₘₐₓ***, wherein the corresponding velocity central point is the projective area of the tip of the emitter needle on the metallic mesh;

Step 2: measurement of the radius of the projection area, which comprising: monitoring the ionic wind velocity ***Vᵣ*** at a velocity measuring point deviating from the velocity central point until ***Vᵣ* =*a Vₘₐₓ***; measuring the distance ***r*** between the velocity measuring point and the velocity central point as ***Vᵣ* =*****a Vₘₐₓ**,* wherein ***a*** is a constant in a range from 0.3 to 0.7;

Step 3: needle-to-mesh configuration, which comprising: setting the distance between the tips of the emitter needles and the metallic mesh in the range of 0.7***L*** to 1.3***L***, and setting the distance between tips of any two adjacent emitter needles in the range of 0.7***r*** to 1.3***r***.

The needle-to-mesh electrode configuration method provided by the present invention discloses an optimum positional design of the emitter needles and the metallic mesh, in which the distance between the emitter needles and the metallic mesh could ensure a comparatively large ionic wind velocity and the array of the emitter needles could be matched with the size of the metallic mesh. Accordingly, the number of the emitter needles could be determined based on the size of the metallic mesh to create the ionic wind with high capacity and uniform distribution, and thereby the air velocity, intensity and efficiency of the ionic wind generating module are improved. At the same time, under the premise of the same ionic wind volume, the number of needles can be effectively reduced, so that the power consumption is minimized.

### Brief description of the drawings

FIG. 1 is a schematic structural view 1 of an embodiment of an ionic wind generating module according to the present invention;
FIG.2 is a schematic structural view 2 of an embodiment of an ionic wind generating module according to the present invention;
FIG.3 is a cross-sectional view of an embodiment of an ionic wind generating module according to the present invention.

### Detailed description

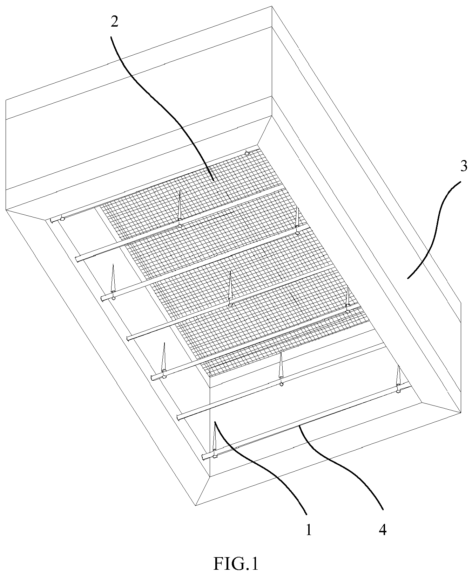

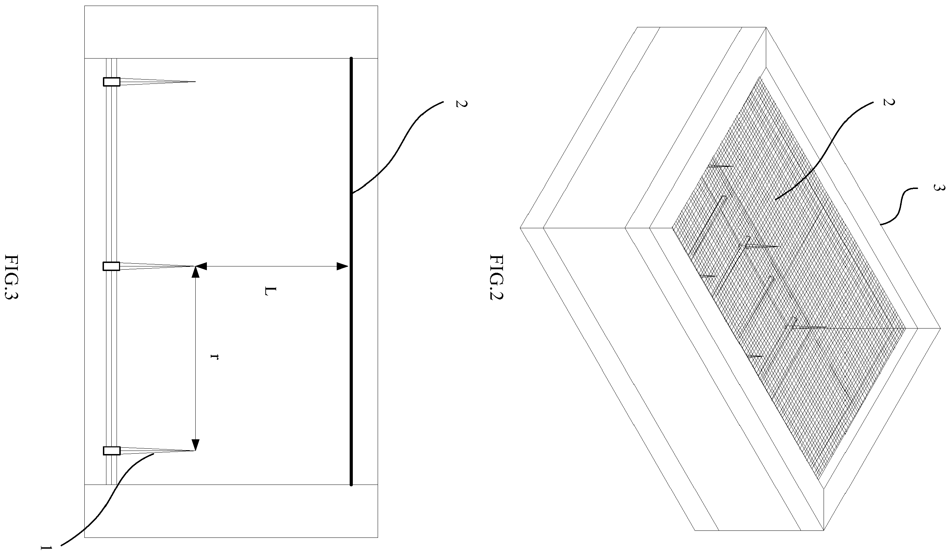

As shown in FIG.**1** to FIG. **3****,** an ionic wind generating module comprises a plurality of emitter needles **1,** a metallic mesh **2,** a flow duct **3** and a needle support **4,** wherein the emitter needle **1** arranged in an array are disposed at one side of the metallic mesh **2,** and the metallic mesh **2** and the needle support **4** are arranged within the flow duct **3.** The distance between each of the tips of the emitter needles **1** and the metallic mesh **2** is in the range of 0.7***L*** to 1.3***L***, and the distance between any two tips of adjacent emitter needles is in the range of 0.7***r*** to 1.3r, wherein ***L*** is the distance between one of the emitter needles **1** and the metallic mesh **2** while the ionic wind velocity at an air velocity central point of the metallic mesh **2** reaches the maximum value ***V**ₘₐₓ*, and the air velocity central point is the corresponding projective point of the tip of the one emitter needle **1** on the metallic mesh **2;** ***r*** is the distance between an air velocity measuring point, which is deviated from the air velocity central point, and the air velocity central point, wherein ***Vᵣ*** is the ionic wind velocity at the velocity measuring point and ***Vᵣ* =*****a V**ₘₐₓ*, wherein ***a*** is a constant in a range from 0.3 to 0.7.

The present invention discloses a needle-to-mesh electrode configuration method to arrange the emitter needle **1** and the metallic mesh **2** in the ionic wind generating module, which comprises the following steps:
Step 1: ionic wind velocity test, which comprises: adjusting the distance between a single emitter needle **1** and the metallic mesh **2** to enable the ionic wind velocity at the corresponding air velocity central point to reach its maximum value under the premise that the voltage between the emitter needles **1** and the metallic mesh **2** is unchanged; and then measuring the adjusted distance ***L*** between the emitter needle **1** and the metallic mesh **2** as the ionic wind velocity at the corresponding air velocity central point maintaining at its maximum value, wherein the velocity central point is the corresponding projective area of the tip of the one emitter needle 1 on the metallic mesh **2.** To be specific, under the premise of the unchanged voltage in the gap between the emitter needles 1 and the metallic mesh **2,** during the process to accurately adjust the distance between one of the emitter needles 1 and the metallic mesh **2,** the ionic wind velocity at the corresponding velocity central point could be monitored by an anemometer until the moment as it reaches the maximum ionic wind velocity, and then the adjusted distance is the optimum distance between the emitter needle **1** and the metallic mesh **2** which could be determined by measuring to ensure the ionic wind velocity produced by the one single emitter needle be at its maximum. The distances ***L*** and ***r*** further might depend on parameters as the materials of the emitter needle **1,** the radius of curvature of the needle tips and the length of the emitter needle **1.** That means if the type of the emitter needle **1** is different, the distances ***L*** and ***r*** may vary.

Step 2: measurement of the radius of the projection area, which comprises: monitoring the ionic wind velocity ***V**ᵣ* at a point deviating from the velocity central point until ***V**ᵣ* **=*****a V**ₘₐₓ*, and measuring the distance ***r*** between the velocity measuring point and the velocity central point, wherein ***a*** is a constant in a range from 0.3 to 0.7. To be specific, on one hand, the ionic wind velocity will become weaker due to the fact that the ionic wind produced by either of the adjacent emitter needles might be counteracted by the other if adjacent emitter needles are arranged too close, and on the other hand, the ionic wind also could be weakened or unevenly distributed if the emitter needles **1** are arranged too loose. Therefore, to avoid such two circumstances, an effective ionic wind velocity area on the metallic mesh **2** could be determined by measuring the adjusted distance between the velocity measuring point and the velocity central point as the measured ionic wind velocity ***V**ᵣ* at a point deviating from the velocity central point reaches ***a V**ₘₐₓ*, namely ***Vᵣ* =*****a Vₘₐₓ**.*

Step 3: needle-to-mesh configuration, which comprises: setting the distance between the tips of the emitter needles ***1*** and the metallic mesh ***2*** in the range of 0.7***L*** to 1.3***L***, and setting the distance between tips of any two adjacent emitter needles **1** in the range of 0.7***r*** to 1.3***r***. To be specific, the needle-to-mesh configuration could reach an optimum state as both of the distance between the emitter needles **1** and the metallic mesh **2** and the distance between tips of any two adjacent emitter needles **1** being set in the ideal ranges respectively. Further, the distance between the tips of the emitter needles **1** and the metallic mesh **2** in the range of 0.7***L*** to 1.3***L*** could ensure the maximum ionic wind volume produced between a single emitter needle and the metallic mesh. The distance between tips of any two adjacent emitter needles **1** in the range of 0.7***r*** to 1.3***r*** could avoid the ionic wind produced by either of adjacent emitter needles being counteracted by the other, and could further ensure that part of the effective ionic wind velocity areas are overlapped to achieve an projection effect as produced by a shadowless lamp, so that the ionic wind could be distributed in a more uniform state. The emitter needles are parallel with each other and the overall configuration of three adjacent emitter needles are in a layout of the shape of an equilateral triangle, which could enhance the uniformity of ionic wind distribution. The tips of the emitter needles are all arranged in one plane, such that the plane where the tips of the emitter needles in is parallel with the plane where the metallic mesh 2 on and the emitter needles are perpendicular to the plane where the metallic mesh 2 on, so as to ensure the same intensity of the ionic wind produced by every single of the emitter needles. Preferably, the distance between the tips of the emitter needles 1 and the metallic mesh 2 is set as ***L***, and the distance between the tips of two adjacent emitter needles 1 is set as *r.*

The ionic wind generating module and the needle-to-mesh electrode configuration method provided by the present invention discloses an optimum positional design of the emitter needle and the metallic mesh, in which the distance between the emitter needles and the metallic mesh could ensure a comparatively large ionic wind velocity and the array of the emitter needles could be matched with the size of the metallic mesh. Accordingly, the number of the emitter needles could be determined based on the size of the metallic mesh to create the ionic wind with high capacity and uniform distribution, and thereby improving the air velocity, intensity and efficiency of the ionic wind generating module.

While the invention has been specifically described in connection with certain specific embodiments thereof, it is to be understood that this is by way of illustration and not of limitation. This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art.

## Claims

1. A needle-to-mesh electrode configuration method of an ionic wind generating module, wherein the ionic wind generating module comprises a metallic mesh (2) and a plurality of emitter needles (1) in an array disposed at one side of the metallic mesh (2), each emitter needle including a tip, the tips of the plurality of emitter needles being arranged in one plane, and wherein the metallic mesh (2) is arranged so as to be parallel to the plane defined by the tips of the plurality of emitter needles, the method comprising:
Step 1: ionic wind velocity test, which comprises: adjusting a distance between a single emitter needle (1) and the metallic mesh (2) to enable an ionic wind velocity at a corresponding air velocity central point on the metallic mesh (2) to reach a maximum value under the premise that a voltage between the emitter needle (1) and the metallic mesh (2) is unchanged; measuring the adjusted distance ***L*** between the emitter needle (1) and the metallic mesh (2) as the ionic wind velocity at the corresponding air velocity central point is maintained at its maximum value ***V**ₘₐₓ*, wherein the corresponding velocity central point is a projective area of a tip of the one emitter needle (1) on the metallic mesh (2);
the method being **characterized in that** it further includes:
Step 2: measurement of a radius of the projection area, which comprises: monitoring the ionic wind velocity ***Vᵣ*** at a velocity measuring point deviating from the velocity central point until ***Vᵣ* =*a Vₘₐₓ***; measuring a distance ***r*** between the velocity measuring point and the velocity central point as ***Vᵣ* =*****a Vₘₐₓ**,* wherein ***a*** is a constant in a range from 0.3 to 0.7;
Step 3: needle-to-mesh configuration, which comprises: setting the distance between the tip of the emitter needle (1) and the metallic mesh (2) in the range of 0.7***L*** to 1.3***L***, and setting the distance between tips of any two adjacent emitter needles (1) in the range of 0.7***r*** to 1.3***r***,
wherein in Step 3, the needle-to-mesh configuration further comprises: enabling the emitter needles (1) to be parallel with each other, and enabling any three adjacent emitter needles (1) to be configured in a layout of an equilateral triangle.

2. The needle-to-mesh electrode configuration method of ionic wind generating module according to the claim 1, wherein in Step 3, the needle-to-mesh configuration further comprises: enabling the emitter needles to be perpendicular to the plane where the metallic mesh (2) on.

3. The needle-to-mesh electrode configuration method of ionic wind generating module according to the claim 1, wherein in Step 3, the needle-to-mesh configuration further comprises: setting the distance between the tips of the emitter needles (1) and the metallic mesh (2) as ***L***, and setting the distance between tips of any two adjacent emitter needles (1) as *r.*

## Patentansprüche

1. Konfigurationsverfahren einer Nadel-zu-Gitterelektrode eines Ionenwinderzeugungsmoduls, wobei das Ionenwinderzeugungsmodul ein metallisches Maschensieb (2) und mehrere Emitternadeln (1) in einem Feld umfasst, das auf einer Seite des metallischen Maschensiebs (2) angeordnet ist, wobei jede Emitternadel eine Spitze umfasst, wobei die Spitzen der mehreren Emitternadeln in einer Ebene angeordnet sind, und wobei das metallische Maschensieb (2) so eingerichtet ist, dass es parallel zu der Ebene ist, die durch die Spitzen der mehreren Emitternadeln definiert ist, das Verfahren Folgendes umfassend:
Schritt 1: Ionenwindgeschwindigkeitstest, der Folgendes umfasst: Einstellen eines Abstands zwischen einer einzelnen Emitternadel (1) und dem metallischen Maschensieb (2), um zu ermöglichen, dass eine Ionenwindgeschwindigkeit an einem entsprechenden zentralen Punkt der Luftgeschwindigkeit auf dem metallischen Maschensieb (2) einen Maximalwert unter der Prämisse erreicht, dass eine Spannung zwischen der Emitternadel (1) und dem metallischen Maschensieb (2) unverändert ist; Messen des eingestellten Abstands L zwischen der Emitternadel (1) und dem metallischen Maschensieb (2), während die Ionenwindgeschwindigkeit an dem entsprechenden zentralen Punkt der Luftgeschwindigkeit auf ihrem Maximalwert **Vₘₐₓ** gehalten wird, wobei der entsprechende zentrale Punkt der Geschwindigkeit eine projektive Fläche einer Spitze der einen Emitternadel (1) auf dem metallischen Maschensieb (2) ist;
wobei das Verfahren **dadurch gekennzeichnet ist, dass** es weiterhin Folgendes umfasst:
Schritt 2: Messung eines Radius der Projektionsfläche, was Folgendes umfasst: Überwachen der Ionenwindgeschwindigkeit **Vᵣ** an einem Geschwindigkeitsmesspunkt, der von dem zentralen Punkt der Geschwindigkeit abweicht, bis **Vᵣ = a Vₘₐₓ** ist; Messen eines Abstands **r** zwischen dem Geschwindigkeitsmesspunkt und dem zentralen Punkt der Geschwindigkeit als **Vᵣ = a Vₘₐₓ**, wobei **a** eine Konstante in einem Bereich zwischen 0,3 und 0,7 ist;
Schritt 3: Nadel-zu-Maschensieb-Konfiguration, die Folgendes umfasst: Einstellen des Abstands zwischen der Spitze der Emitternadel (1) und dem metallischen Maschensieb (2) in dem Bereich zwischen 0,7 **L** und 1,3 **L** und Einstellen des Abstands zwischen Spitzen von beliebigen zwei benachbarten Emitternadeln (1) in dem Bereich zwischen 0,7 **r** und 1,3 **r**,
wobei in Schritt 3 die Nadel-zu-Maschensieb-Konfiguration weiterhin Folgendes umfasst: Ermöglichen, dass die Emitternadeln (1) parallel zueinander sind, und Ermöglichen, dass beliebige drei benachbarte Emitternadeln (1) in einer Anordnung eines gleichseitigen Dreiecks eingerichtet sind.

2. Konfigurationsverfahren einer Nadel-zu-Gitterelektrode des Ionenwinderzeugungsmoduls nach Anspruch 1, wobei in Schritt 3 die Nadel-zu-Maschensieb-Konfiguration weiterhin Folgendes umfasst: Ermöglichen, dass die Emitternadeln senkrecht zu der Ebene sind, auf der das metallische Maschensieb (2) ist.

3. Konfigurationsverfahren einer Nadel-zu-Gitterelektrode des Ionenwinderzeugungsmoduls nach Anspruch 1, wobei in Schritt 3 die Nadel-zu-Maschensieb-Konfiguration weiterhin Folgendes umfasst: Einstellen des Abstands zwischen den Spitzen der Emitternadeln (1) und dem metallischen Maschensieb (2) als **L** und Einstellen des Abstands zwischen Spitzen von beliebigen zwei benachbarten Emitternadeln (1) als **r**.

## Revendications

1. Procédé de configuration d'électrodes de type aiguilles-treillis d'un module de génération de vent ionique, le module de génération de vent ionique comprenant un treillis métallique (2) et une pluralité d'aiguilles émettrices (1) dans un réseau disposé sur un côté du treillis métallique (2), chaque aiguille émettrice comportant une pointe, les pointes de la pluralité d'aiguilles émettrices étant disposées dans un plan, et le treillis métallique (2) étant disposé de manière à être parallèle au plan défini par les pointes de la pluralité d'aiguilles émettrices, le procédé comprenant :
étape 1 : test de vitesse de vent ionique, qui comprend : le réglage d'une distance entre une aiguille émettrice individuelle (1) et le treillis métallique (2) pour permettre à une vitesse de vent ionique à un point central de vitesse d'air correspondant sur le treillis métallique (2) d'atteindre une valeur maximale en partant du principe qu'une tension entre l'aiguille émettrice (1) et le treillis métallique (2) est inchangée ; la mesure de la distance réglée **L** entre l'aiguille émettrice (1) et le treillis métallique (2) lorsque la vitesse de vent ionique au point central de vitesse d'air correspondant est maintenue à sa valeur maximale ***V**ₘₐₓ*, le point central de vitesse correspondant étant une aire de projection d'une pointe de l'aiguille émettrice individuelle (1) sur le treillis métallique (2) ;
le procédé étant **caractérisé en ce qu'**il comporte en outre :
étape 2 : mesure d'un rayon de l'aire de projection, qui comprend : la surveillance de la vitesse de vent ionique ***Vᵣ*** à un point de mesure de vitesse s'écartant du point central de vitesse jusqu'à ce que ***Vᵣ = a Vₘₐₓ*** ; la mesure d'une distance **r** entre le pont de mesure de vitesse et le point central de vitesse lorsque ***Vᵣ* = a** ***V**ₘₐₓ*, **a** étant une constante dans une gamme de 0,3 à 0,7 ;
étape 3 : configuration aiguilles-treillis, qui comprend : le réglage de la distance entre la pointe de l'aiguille émettrice (1) et le treillis métallique (2) dans la gamme de 0,7***L*** à 1,3***L***, et le réglage de la distance entre les pointes de deux aiguilles émettrices adjacentes (1) quelles qu'elles soient dans la gamme de 0,7***r*** à 1,3***r***,
dans lequel, à l'étape 3, la configuration aiguilles-treillis comprend en outre : le fait de faire en sorte que les aiguilles émettrices (1) soient parallèles les unes aux autres, et le fait de faire en sorte que trois aiguilles émettrices adjacentes (1) quelles qu'elles soient soient configurées dans une disposition d'un triangle équilatéral.

2. Procédé de configuration d'électrodes de type aiguilles-treillis d'un module de génération de vent ionique selon la revendication 1, dans lequel, à l'étape 3, la configuration aiguilles-treillis comprend en outre : le fait de faire en sorte que les aiguilles émettrices soient perpendiculaires au plan où se situe le treillis métallique (2).

3. Procédé de configuration d'électrodes de type aiguilles-treillis d'un module de génération de vent ionique selon la revendication 1, dans lequel, à l'étape 3, la configuration aiguilles-treillis comprend en outre : le réglage de la distance entre les pointes des aiguilles émettrices (1) et le treillis métallique (2) à ***L*,** et le réglage de la distance entre les pointes de deux aiguilles émettrices adjacentes (1) quelles qu'elles soient à ***r*.**
